# EUROPÄISCHE PATENTSCHRIFT

(11) **EP 1 481 469 B1**
(45) Veröffentlichungstag und Bekanntmachung des Hinweises auf die Patenterteilung: **12.11.2008**
(21) Anmeldenummer: 03704288.4
(22) Anmeldetag: 04.02.2003
(51) Int. Cl.: H03B 1/04

(54) **SCHALTUNGSANORDNUNG ZUR ERZEUGUNG EINES REFERENZSTROMES UND OSZILLATORSCHALTUNG MIT DER SCHALTUNGSANORDNUNG**
CIRCUIT SYSTEM FOR GENERATING A REFERENCE CURRENT AND OSCILLATOR CIRCUIT COMPRISING SAID CIRCUIT SYSTEM
CIRCUIT UTILISE POUR LA PRODUCTION D'UN COURANT DE REFERENCE ET UN MONTAGE D'OSCILLATEUR CONTENANT CE CIRCUIT

(30) Priorität: 01.03.2002 DE 10209044
(43) Veröffentlichungstag der Anmeldung: 01.12.2004
(73) Patentinhaber: Infineon Technologies AG, 81669 München (DE)
(72) Erfinder: OEHM, Jürgen, 40885 Ratingen (DE)
(74) Vertreter: Fischer, Volker
(86) Internationale Anmeldenummer: PCT/DE2003/000308
(87) Internationale Veröffentlichungsnummer: WO 2003/075450

(56) Entgegenhaltungen:
- US-A- 5 440 277
- US-A- 5 722 052
- US-A- 5 770 962
- US-A- 5 880 579
- US-A- 5 929 620
- US-A- 6 157 180

## Beschreibung

Die vorliegende Erfindung betrifft eine Schaltungsanordnung zur Erzeugung eines Referenzstromes sowie eine Oszillatorschaltung mit der Schaltungsanordnung zur Erzeugung eines Referenzstromes.

Oszillatoren mit einer über einen weiten Bereich einstellbaren Schwingfrequenz werden normalerweise als LC-Oszillatoren realisiert. Die Frequenz des Schwingkreises wird dabei durch zumindest eine Kapazität und zumindest eine Induktivität bestimmt. Die Oszillationsfrequenz ergibt sich dabei aus dem Kehrwert des Produktes aus 2π und der Wurzel aus dem LC-Produkt.

Zur Verstellung der Schwingfrequenz wird üblicherweise die Induktivität konstant, die Kapazität jedoch verstellbar ausgeführt. Als verstellbare Kapazitäten werden normalerweise Varaktordioden eingesetzt, bei denen die Sperrschichtkapazität abhängig von einem angelegten Gleichspannungspotential ist.

Ein wichtiges Anwendungsgebiet derartiger LC-Oszillatoren sind Mobilfunkgeräte, bei denen hochfrequente Trägerschwingungen benötigt werden, um Frequenzkonversionen von hochfrequenten Lagen ins Basisband und umgekehrt vorzunehmen.

Um Verluste in den LC-Schwingkreisen zu kompensieren, werden diese üblicherweise mittels einer sogenannten negativen Impedanz entdämpft. Hierfür sind beispielsweise kreuzgekoppelte MOS-Feldeffekttransistoren vorgesehen, die mit einem Referenzstrom gespeist werden. An den Referenzstrom, der einen LC-Oszillator speist, werden hohe Anforderungen bezüglich seines Phasenrauschens gestellt. Referenzstromgespeiste LC-Oszillatoren sind bezüglich des Phasenrauschens sehr empfindlich auf Stör- und Rauscheinströmungen im Referenzstrom.

In dem Dokument Y.Seong-Mo and K.O.Kenneth, Demonstration of a Switched Resonator Concept in Dual-Band Monolithic CMOS LC-Tuned VCO, IEEE 2001 Custom Integrated Circuits Conference, pp. 205-208, IEEE/CiCC 2001, ISBN 0-7803-6591-7 ist ein Referenzstromgespeister LC-Oszillator, wie oben beschrieben, angegeben.

Die beschriebene Problematik, das Phasenrauschen einer Referenzstromquelle zu verringern, wird bei einem LC-Oszillator in dem Dokument P. Andreani and H. Sjöland, A 2.2 GHz CMOS VCO with Inductive Degeneration Noise Suppression, IEEE 2001 Custom Integrated Circuits Conference, pp. 197-200, IEEE CICC 2001, ISBN 0-7803-6591-7 dadurch verringert, daß in Reihe zur Stromquelle LC-Filterstrukturen vorgesehen sind. Derartige Filter sind jedoch aufwendig zu realisieren.

US-A-6157180 offenbart eine Versorgungsspannungsreglerschaltung für einen spannungsgesteuerten Oszillator mit verbesserter Unterdrückung von Speisespannungs- und Rausch-Variationen.

Aufgabe der vorliegenden Erfindung ist es, eine Schaltungsanordnung zur Erzeugung eines Referenzstromes sowie eine Oszillatorschaltung mit der Schaltungsanordnung anzugeben, bei denen das Phasenrauschen ohne zusätzliche Filterstrukturen reduziert ist.

Bezüglich der Schaltungsanordnung zur Erzeugung eines Referenzstromes wird die Aufgabe gelöst durch eine Schaltungsanordnung zur Erzeugung eines Referenzstromes, aufweisend
- eine spannungsgesteuerte Stromquelle mit einem Steuereingang und mit einem Ausgang zum Abgreifen des Referenzstroms,
- eine Kapazität, die an den Steuereingang der spannungsgesteuerten Stromquelle angeschlossen ist,
- eine Serienschaltung umfassend einen ersten Verstärker mit einem ersten Verstärkungsfaktor und einen Schalter, welche mit dem Steuereingang der spannungsgesteuerten Stromquelle verbunden ist,
- einen zweiten Verstärker mit einem zweiten Verstärkungsfaktor, welcher mit dem Steuereingang der spannungsgesteuerten Stromquelle verbunden ist, und
- eine Auswahlschaltung, die zum Umschalten zwischen einer ersten und einer zweiten Betriebsart der Schaltungsanordnung mit einem Steuereingang des Schalters verbunden ist.

Gemäß dem vorliegenden Prinzip kann die Schaltungsanordnung zur Erzeugung eines Referenzstromes mit Vorteil in zwei Betriebsarten betrieben werden, nämlich in einer ersten Betriebsart, in der der Schalter, der mit dem ersten Verstärker eine Serienschaltung bildet, geschlossen ist und in einer zweiten, in der der Schalter geöffnet ist. In der ersten Betriebsart bestimmen folglich die Verstärkungsfaktoren von erstem und zweitem Verstärker, das Auf- beziehungsweise Umladen der Kapazität sowie das Ansteuern der spannungsgesteuerten Stromquelle, während in der zweiten Betriebsart lediglich der Verstärkungsfaktor des zweiten Verstärkers das Auf- beziehungsweise Umladeverhalten der Kapazität sowie das Ansteuern der spannungsgesteuerten Stromquelle beeinflußt.

Der erste und zweite Verstärker sind bevorzugt bezüglich ihrer Treiberstärke, das heißt bezüglich ihres Verstärkungsfaktors so ausgelegt, daß der erste Verstärkungsfaktor größer als der zweite Verstärkungsfaktor ist.

Der erste und der zweite Verstärker können bevorzugt als Differenzverstärker ausgebildet sein.

Bevorzugt sind der erste und der zweite Verstärker differenzspannungsgesteuerte Stromquellen.

Der erste Verstärkungsfaktor des ersten Verstärkers ist bevorzugt gerade so ausgelegt, das ein besonders schnelles Aufladen der Kapazität, die an den Steuereingang der spannungsgesteuerten Stromquelle angeschlossen ist, gewährleistet wird.

Der Verstärkungsfaktor des zweiten Verstärkers ist bevorzugt so dimensioniert, daß gerade die Erhaltungsladung der Kapazität bereitgestellt wird, das heißt, daß die Treiberfähigkeit des zweiten Verstärkers gerade ausreicht, um Leckströme der Kapazität und/oder des Schalters zu kompensieren.

Der zweite Verstärker, der folglich eine verhältnismäßig geringe Verstärkung beziehungsweise eine geringe Treiberfähigkeit hat, kann gemäß vorliegendem Prinzip besonders rauscharm ausgebildet sein.

Da mittels des zuschaltbaren Verstärkers ein besonders schnelles Auf- oder Umladen der Kapazität möglich ist, kann die vorliegende Schaltungsanordnung insbesondere zur Stromversorgung solcher LC-Oszillatoren verwendet werden, welche in Mobilfunkgeräten vorgesehen sind, die einen Standby-Modus haben und nicht ständig eingeschaltet sind.

Wie erläutert ist es gemäß vorliegenden Prinzip möglich, zum einen die Erzeugung des Referenzstromes mit besonders geringen Phasenrauschen zu ermöglichen und zum anderen einen Stromsparbetrieb zu unterstützen.

Insgesamt eignet sich das vorliegende Prinzip folglich besonders gut zum Betrieb von LC-Oszillatoren in Mobilfunkgeräten.

Auch andere Funktionseinheiten in Hochfrequenz-Schaltkreisen, die mit Stromquellen betrieben werden, welche ein geringes Rauschen haben sollen, sind mit vorliegenden Prinzip bevorzugt ansteuerbar, beispielsweise Hochfrequenzmischer.

Gemäß einer weiteren, bevorzugten Ausführungsform der vorliegenden Erfindung sind der erste und der zweite Verstärker in MOS-Schaltungstechnik ausgebildete, gesteuerte Stromquellen, mit je einem Differenzverstärker. Die Differenzverstärker umfassen je zwei MOS-Transistoren. Das Kanalweiten- zu Kanallängenverhältnis der MOS-Transistoren im ersten Verstärker ist größer als das Kanalweiten- zu Kanallängenverhältnis der MOS-Transistoren im zweiten Verstärker. Das Kanalweiten- zu Kanallängenverhältnis der MOS-Transistoren im ersten Verstärker ist bevorzugt groß gegenüber dem Wert 1. Das Kanalweitenzu Kanallängenverhältnis der MOS-Transistoren im zweiten Verstärker ist bevorzugt klein gegenüber 1. Mittels der Transistoren im ersten Verstärker mit der großen Kanalweite bei kleiner Kanallänge ist ein schnelles Aufladen der Kapazität möglich. Nach dem Umschalten auf die zweite Betriebsart, in der die MOS-Transistoren im zweiten Verstärker mit der geringen Kanalweite und der hohen Kanallänge wirksam sind, werden Leckströme mit besonders geringen Rauschanteilen auf dem Referenzstrom kompensiert.

Dabei ist der Durchgriff von Störungen aus der Versorgungsspannung auf den Referenzstrom besonders klein. In der zweiten Betriebsart verhält sich die spannungsgesteuerte Stromquelle demnach wie eine ideale, rauschfreie Referenzquelle, ohne daß sich der auf der Kapazität eingespeicherte Referenzspannungswert zeitlich verändert.

Es ist vorteilhaft, den vorliegenden Stellkreis in der Schaltungsanordnung zu einem Regelkreis weiterzubilden, dadurch, daß ein Rückkopplungspfad vorgesehen ist, der den Ausgang der spannungsgesteuerten Stromquelle mit je einem Steuereingang des ersten und des zweiten Verstärkers koppelt.

Mit dem beschriebenen Regelkreis ist ein besonders präzises Einstellen des Referenzstromes möglich, insbesondere jedoch eine hohe Konstanz des eingestellten Referenzstromes, durch Beeinflussen der über der Kapazität abfallenden und die spannungsgesteuerte Stromquelle ansteuernden Referenzspannung.

Die Genauigkeit der beschriebenen Regelung kann dadurch weiter verbessert werden, daß die spannungsgesteuerte Stromquelle als erste spannungsgesteuerte Stromquelle ausgeführt ist und daß eine zweite, spannungsgesteuerte Stromquelle vorgesehen ist, mit einem Steuereingang, der mit dem Steuereingang der ersten spannungsgesteuerten Stromquelle verbunden ist und mit einem Ausgang, der mit dem Eingang des Rückkopplungspfades verbunden ist.

Die zweite, spannungsgesteuerte Stromquelle arbeitet als Referenz-Stromquelle, die mit der gleichen Referenzspannung wie die eigentliche, erste spannungsgesteuerte Stromquelle angesteuert wird. Der Referenzstrom, der an der ersten spannungsgesteuerten Stromquelle ableitbar ist, kann beispielsweise durch Einstellen eines Stromspiegelverhältnisses an erster und zweiter spannungsgesteuerter Stromquelle präzise eingestellt werden.

Eine noch weitere Verbesserung der beschriebenen Regelschleife ist in einfacher Weise dadurch erzielbar, daß erster und zweiter Verstärker neben je einem ersten Steuereingang, der mit dem Rückkopplungspfad verbunden ist, je einen zweiten Steuereingang aufweisen, wobei eine Referenzspannungsquelle vorgesehen ist, welche mit den beiden zweiten Steuereingängen gekoppelt ist.

Eine Referenzspannungsquelle, beispielsweise ein Bandgap-Generator, ermöglicht die Bereitstellung eines besonders präzisen Bezugssignals, mit dessen Hilfe die beiden Verstärker wiederum eine besonders genaue Referenzspannung einstellen können, die wiederum zur Bereitstellung eines sehr präzise einstellbaren Referenzstromes beiträgt.

Die erste und, falls eine zweite vorhanden ist, auch die zweite spannungsgesteuerte Stromquelle sind bevorzugt in MOS-Schaltungstechnik ausgebildet. Dabei ist die spannungsgesteuerte Stromquelle vorzugsweise als MOS-Transistor ausgebildet, der als Stromquelle arbeitet. Bevorzugt ist der Source-Anschluß mit dem Bulk-Anschluss kurzgeschlossen. Bei einem derartigen, als Stromquelle arbeitenden MOS-Transistor bestimmen die Steilheit des Transistors und seine Kanallänge sowie die ihn ansteuernde Referenzspannung die Rauscheigenschaften des bereitgestellten Referenzstromes.

Der Referenzstrom eines als Stromquelle wirkenden MOS-Transistors ist bestimmt durch die zwischen dem Gate- und dem Source-Anschluß des MOS-Transistors anstehende Referenzspannung, welche je nach Betriebszustand vom ersten und/oder zweiten Verstärker bereitgestellt wird. Da mit vorliegendem Prinzip die Rauscheigenschaften der Referenzspannung in der zweiten Betriebsart besonders gering sind, ist auch der Referenzstrom besonders rauscharm.

Bezüglich der Oszillatorschaltung wird die Aufgabe gelöst durch eine Oszillatorschaltung mit einer Schaltungsanordnung wie vorstehend beschrieben, aufweisend
- einen LC-Schwingkreis,
- einen Entdämpfungsverstärker, der mit dem LC-Schwingkreis gekoppelt ist, und
- einen Referenzstromeingang zum Speisen der Oszillatorschaltung, der an den LC-Schwingkreis oder an den Entdämpfungsverstärker angeschlossen ist,
- wobei der Referenzstromeingang an den Ausgang der spannungsgesteuerten Stromquelle der Schaltungsanordnung zur Erzeugung eines Referenzstroms angeschlossen ist.

Aufgrund des besonders rauscharmen und störungsfreien Referenzstroms, der gemäß vorliegendem Prinzip erzeugt werden kann, stellt die erfindungsgemäße Oszillatorschaltung, wie bereits ausführlich erläutert, ein Signal mit einer Schwingfrequenz bereit, welches besonders geringes Phasenrauschen zeigt.

Weitere Einzelheiten und vorteilhafte Ausgestaltung der Erfindung sind Gegenstand der Unteransprüche.

Die Erfindung wird nachfolgend an mehreren Ausführungsbeispielen anhand der Zeichnungen näher erläutert.

Es zeigen:
- Figur 1: ein vereinfachtes Blockschaltbild eines ersten Ausführungsbeispieles einer Schaltungsanordnung zur Erzeugung eines Referenzstromes gemäß vorliegendem Prinzip,
- Figur 2: einen LC-Oszillator mit abstimmbarer Frequenz, bei dem die Schaltungsanordnung gemäß Figur 1 mit Vorteil anwendbar ist,
- Figur 3a: eine ideale MOS-Stromquelle,
- Figur 3b: die Stromquelle gemäß Figur 3a, jedoch zusätzlich mit einem leckstrombehafteten Schalter,
- Figur 3c: die Stromquelle gemäß Figur 3b mit einer rauschbehafteten Kompensationsstromquelle,
- Figur 4: eine Weiterbildung des Ausführungsbeispieles gemäß Figur 1 mit einem Regelkreis,
- Figur 5: den ersten und zweiten Verstärker ausgebildet als Transimpedanzverstärker gemäß den Schaltbildern von Figuren 1, 4 und
- Figur 6: eine Weiterbildung des Transimpedanzverstärkers von Figur 5 gemäß dem vorliegenden Prinzip.

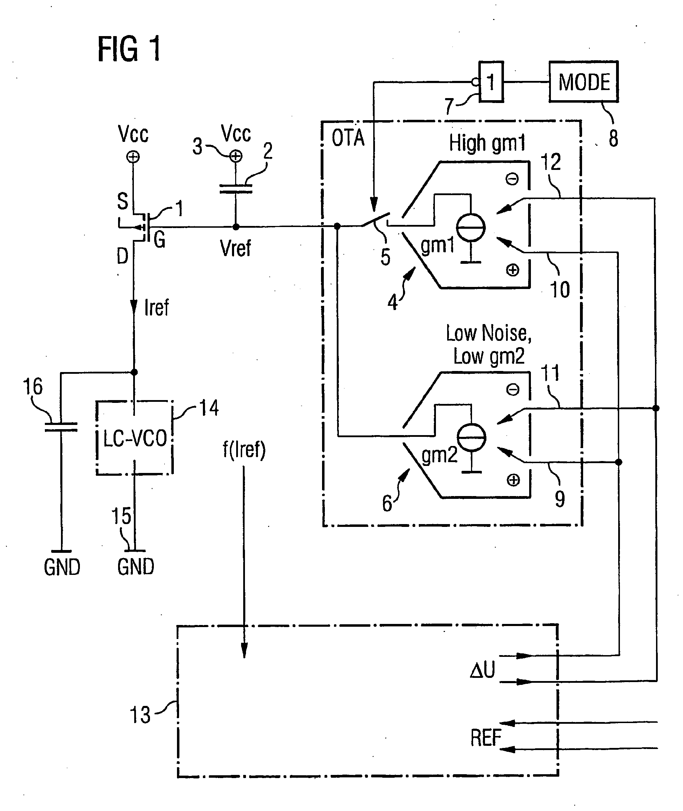

Figur 1 zeigt eine Schaltungsanordnung zur Erzeugung eines Referenzstromes I_{ref}, mit einer spannungsgesteuerten Stromquelle 1, die als MOS-Feldeffekttransistor ausgebildet ist, mit einer Kapazität 2, die mit einem Anschluß mit dem Gate-Anschluß der Stromquelle 1 und mit einem weiteren Anschluß mit einem Versorgungspotentialanschluß 3 verbunden ist, mit einem ersten Verstärker 4, dessen Ausgang über einen Schalter 5 mit dem Steuereingang der Stromquelle 1 verbunden ist und mit einem zweiten Verstärker 6, dessen Ausgang ebenfalls mit dem Steuereingang, das heißt mit dem Gate-Anschluß der Stromquelle 1 verbunden ist. Der Schalter 5 weist einen Steueranschluß auf, der über einen Inverter 7 an den Ausgang einer Auswahlschaltung 8 gekoppelt ist, die von einer ersten Betriebsart in eine rauscharme, zweite Betriebsart umschaltet. Erster und zweiter Verstärker 4, 6 sind jeweils als differenzspannungsgesteuerte Stromquelle aufgebaut und in MOS-Schaltungstechnik realisiert. Erster und zweiter Verstärker haben je einen ersten Eingang 9, 10 sowie je einen zweiten Eingang 11, 12. Erste und zweite Eingänge des ersten und zweiten Verstärkers 4, 6 sind mit einer rückkoppelnden Referenzeinheit 13 verbunden, welche an ihrem Ausgang eine Differenzspannung ΔU bereitstellt. Die Referenzeinheit 13 weist zwei Steuereingänge auf, an denen zum einem ein Referenzsignal (Ref) zugeführt wird und zum anderen ein vom Referenzstrom abgeleitetes Signal f(I_{ref}) zugeführt wird. Der Ausgang der spannungsgesteuerten Stromquelle 1, nämlich der Drain-Anschluß des MOS-Stromquellentransistors 1, ist mit einem Referenzstromeingang eines spannungsgesteuerten LC-Oszillators 14 verbunden, der weiterhin mit einem Bezugspotentialanschluß 15 gekoppelt ist. Parallel zum LC-Oszillator 14 ist eine weitere Kapazität 16 gegen Bezugspotentialanschluß 15 geschaltet. Der Source-Anschluß des P-Kanal-Stromquellentransistors 1 ist mit dem Versorgungspotentialanschluß 3 sowie mit dem Bulk-Anschluß des Stromquellentransistors 1 verbunden. Die Steilheit gml des ersten Verstärkers 4 ist bedeutend größer als die Steilheit gm2 des zweiten Verstärkers 6. Der zweite Verstärker 6 ist als rauscharmer Verstärker ausgebildet.

Die Treiberfähigkeit des ersten Verstärkers 4 ist so ausgelegt, daß ein besonders schnelles Auf- und Umladen der Kapazität 2 bei geschlossenem Schalter 5 möglich ist. Schalter 5 wird beispielsweise beim Einschalten des Oszillators 14, nach einem Standby-Betrieb desselben, geschlossen, bis die Kapazität 2 auf ihre Soll-Spannung aufgeladen ist, nämlich diejenige Spannung, die am Ausgang der Stromquelle 1 gerade den Referenzstrom hervorruft. Die Steilheit gm2 des zweiten Verstärkers 6 ist so ausgelegt, daß Leckströme im Schalter 5 sowie Leckströme der Kapazität 2 gerade kompensiert werden, derart, daß die über der Kapazität 2 abfallende Spannung konstant bleibt. In dieser zweiten Betriebsart ist der Schalter 5 geöffnet. Aufgrund der hierfür erforderlichen geringen Treiberfähigkeit gm2 des zweiten Verstärkers 6 kann dieser besonders rauscharm ausgelegt werden, so daß im Normalbetrieb der Oszillator 14 mit einem Referenzstrom I_{ref} gespeist werden kann, wobei der Oszillator 14 ein besonders geringes Phasenrauschen hat.

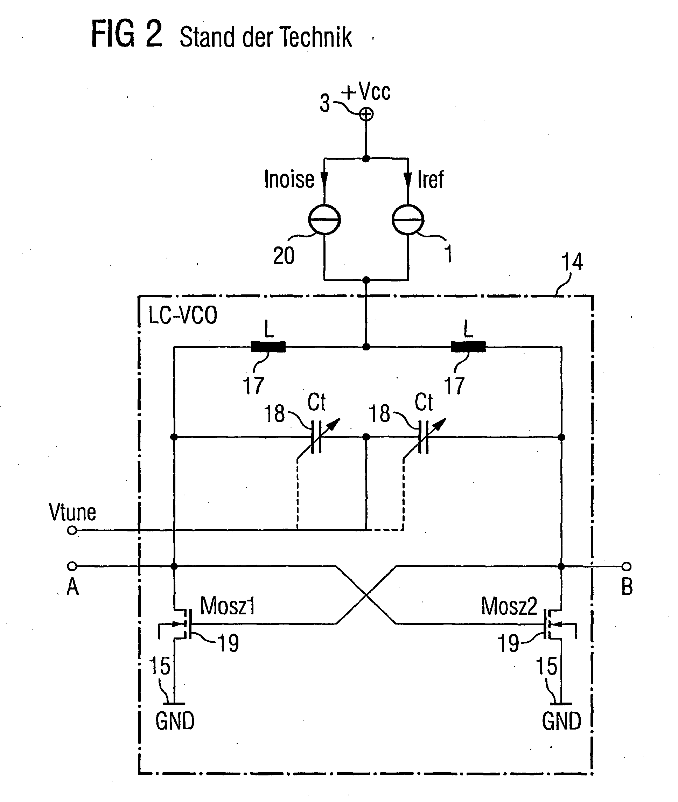

Figur 2 zeigt einen herkömmlichen, spannungsgesteuerten LC-Oszillator 14 gemäß Figur 1. Der LC-Oszillator ist symmetrisch aufgebaut mit zwei Festwert-Induktivitäten 17, die mit je einem Anschluß miteinander und mit dem Ausgang einer Referenzstromquelle 20 verbunden sind. Parallel zur Referenzstromquelle 20 ist eine Rauschstromquelle 19 eingezeichnet, welche parasitäre Eigenschaften kennzeichnet. Die Induktivitäten 17 sind mit je einem verstellbaren kapazitiven Element, nämlich je einer Varaktor-Diode 18 gekoppelt. Die Varactor-Dioden 18 weisen je einen Steuereingang auf, an dem eine Abstimmspannung Vₜᵤₙₑ zugeführt wird. Dieser abstimmbare LC-Schwingkreis ist mit einem Entdämpfungsverstärker gekoppelt. Der Entdämpfungsverstärker umfaßt zwei kreuzgekoppelte N-Kanal-Feldeffekttransistoren 19, die mit Bezugspotentialanschluß 15 verbunden sind. Am symmetrischen Schaltungsknoten zwischen LC-Tank 17, 18 und Entdämpfungsverstärker 19 kann das Ausgangssignal A, B des Oszillators 14 abgegriffen werden.

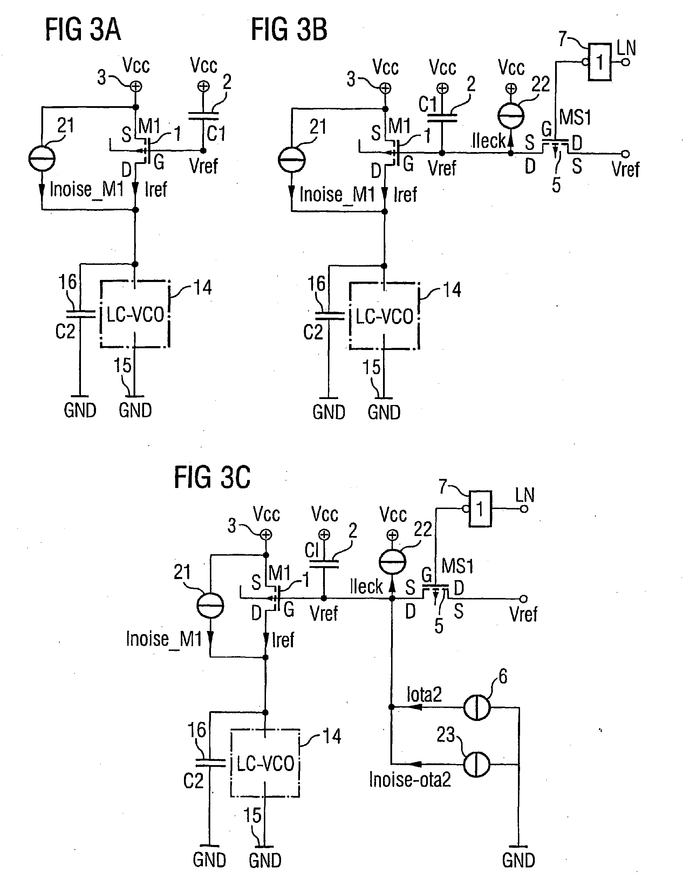

Figuren 3a bis 3c dienen zum besseren Verständnis der Rausch-Verhältnisse bei der Ansteuerung von LC-Oszillatoren mit einem Referenzstrom.

Figur 3a zeigt den LC-Oszillator 14 mit paralleler Stützkapazität 16, der zu seiner Referenzstromversorgung an die Referenzstromquelle 1 angeschlossen ist, deren Steuereingang mit der Kapazität 2 verbunden ist. Parallel zur gesteuerten Strecke der spannungsgesteuerten Stromquelle 1 ist eine Stromquelle 21 eingezeichnet, welche die parasitären Rauscheinströmungen der Stromquelle 1 repräsentiert. Mit der Stromquelle 21 stellt die gesteuerte Stromquelle 1 einen realen MOS-FET dar. Bei einer derartigen Referenzstromversorgung des Oszillators 14 sind keine weiteren Rauschquellen vorhanden. Der vom Transistor 1 selbst hervorgerufene Rauschbeitrag ist verhältnismäßig klein.

Figur 3b zeigt die Schaltung gemäß Figur 3a, jedoch erweitert um den hier als MOS-Schalter 5 ausgebildeten Schalter, der den Gate-Anschluß der Stromquelle 1 mit dem hier nicht eingezeichneten Verstärker 4 koppelt. Der Steuereingang, das heißt der Gate-Anschluß des P-Kanal-Schalttransistors 5 ist mit Inverter 7 verbunden. Der Schalter 5 ruft jedoch Leckströme hervor, welche durch eine zusätzliche, parasitäre Stromquelle 22 repräsentiert werden. Die von dem Schalter 5 hervorgerufenen, unvermeidlichen Leckströme, die von Stromquelle 22 repräsentiert werden, führen jedoch zu einer Entladung der Kapazität 2, welche unerwünscht ist.

Figur 3c ist eine Weiterbildung der Schaltung von Figur 3b und weist neben den dort angegebenen Bauteilen zusätzlich eine Stromquelle 6 auf, welche gerade die parasitären Leckströme kompensiert, die von Stromquelle 22 repräsentiert werden. Parallel zur Stromquelle 6 ist eine Rauschstromquelle 23 eingezeichnet, welche parasitäre Rauschströme der Stromquelle 6 repräsentiert. Die Stromquelle 6 entspricht dem zweiten, rauscharmen Verstärker 6 von Figur 1.

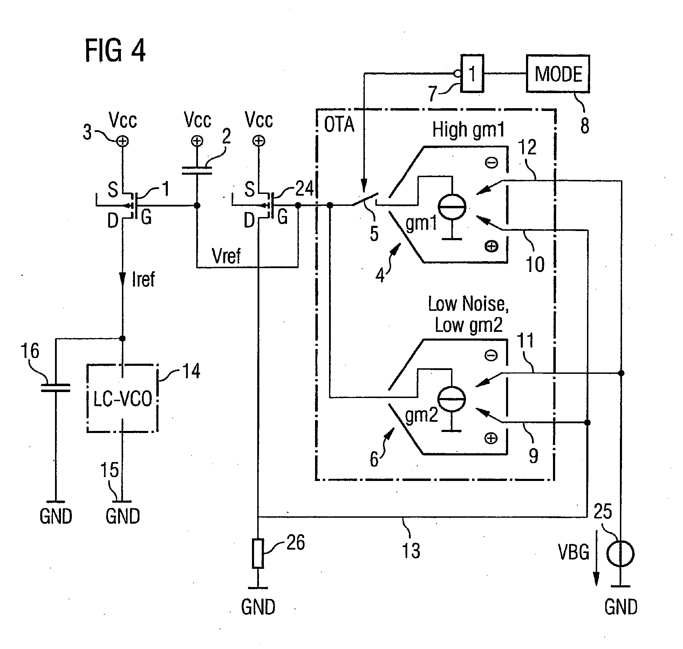

Figur 4 zeigt eine Weiterbildung des Ausführungsbeispieles gemäß Figur 1 mit einer Regelschleife zum Regeln des Referenzstromes I_{ref}. Hierfür ist eine zweite, der spannungsgesteuerten Stromquelle 1 nachgebildete spannungsgesteuerte Stromquelle 24 vorgesehen, welche mit der spannungsgesteuerten Stromquelle 1 einen Stromspiegel bildet. Dabei ist der Source-Anschluß der zweiten spannungsgesteuerten Stromquelle 24 mit deren Bulk-Anschluß und dem Versorgungspotentialanschluß 3 verbunden. Der Gate-Anschluß der zweiten spannungsgesteuerten Stromquelle 24 ist mit demjenigen der ersten spannungsgesteuerten Stromquelle und damit mit dem Schalter 5 sowie dem Ausgang des zweiten Verstärkers 6 verbunden. Der Drain-Anschluß der als MOS-Stromquelle ausgebildeten spannungsgesteuerten Stromquelle 24 ist mit dem ersten Eingang 10 des ersten Verstärkers und dem ersten Eingang 9 des zweiten Verstärkers verbunden. Die zweiten Eingänge 11, 12 von erstem und zweiten Verstärker 4, 6 sind an eine Referenzspannungsquelle 25 angeschlossen, welche gegen Bezugspotentialanschluß 15 geschaltet ist. Der Drain-Anschluß der zweiten spannungsgesteuerten Stromquelle 24 ist außerdem über einen Widerstand 26 gegen Bezugspotentialanschluß 15 geschaltet. Abgesehen von der Ausführung des Rückkoppelungspfads 13 entspricht die Schaltungsanordnung zur Erzeugung eines Referenzstromes gemäß Figur 4 in Aufbau und vorteilhafter Wirkungsweise derjenigen von Figur 1. Insoweit wird die Figurenbeschreibung hier an dieser Stelle nicht noch einmal wiederholt.

Die Bandgap-Referenzspannungsquelle 25 stellt eine Bandgap-Spannung von typischerweise 1,2 Volt bereit. Über die beschriebene Regelschleife stellt sich dieselbe Bandgap-Spannung auch über dem Widerstand 26 ein und liegt demnach am Drain-Anschluß der zweiten spannungsgesteuerten Stromquelle 24 an. Der am Drain-Anschluß dieser MOS-Stromquelle 24 bereitgestellte Strom entspricht damit dem Quotienten aus Bandgap-Spannung und Widerstand 26. Obwohl die Rückkopplungsschleife an den eigentlich nicht-invertierenden Eingängen 9, 10 des ersten und zweiten Verstärkers angeschlossen ist, handelt es sich selbstverständlich um eine negative Rückkoppelung, da die Stromquelle 24 invertierendes Verhalten zeigt. Erste und zweite Stromquelle 1, 24 bilden einen Stromspiegel mit einem festen, aber einstellbaren Spiegelverhältnis, so daß der Referenzstrom I_{ref} am Ausgang der ersten spannungsgesteuerten Stromquelle 1 durch dieses Spiegelverhältnis sowie den Widerstandswert des Widerstandes 26 in gewünschter Weise und sehr präzise einstellbar ist.

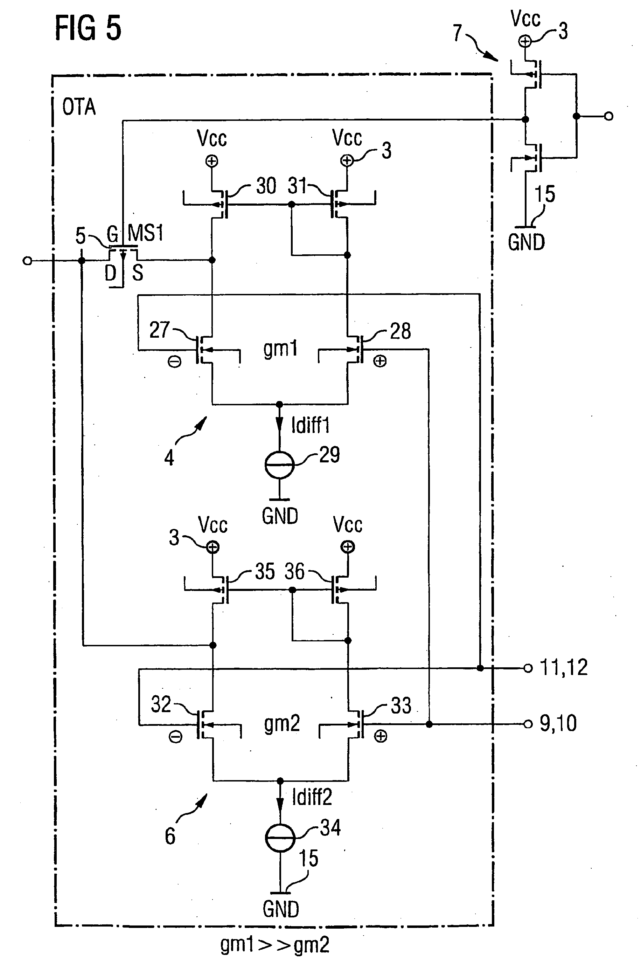

Figur 5 zeigt eine beispielhafte Ausführungsform des ersten und zweiten Verstärkers 4, 6, wie sie bei den Gegenständen bei Figur 1 und Figur 4 vorgesehen sind, als in MOS-Schaltungstechnik ausgebildete Transimpedanzverstärker, sogenannte Operational Transimpedance Amplifier, OTA. Außerdem ist der Schalter 5 als MOS-Transistorschalter sowie Inverter 7 als CMOS-Inverter ausgebildet.

Der erste Verstärker 4, der die erste Steilheit gm1 hat, umfaßt zwei NMOS-Transistoren 27, 28, welche mit ihrem Source-Anschlüssen miteinander und über eine erste Stromquelle 29 mit Bezugspotentialanschluß 15 verbunden sind. Die Transistoren 27, 28 bilden somit einen Differenzverstärker. An die beiden Drain-Anschlüsse der Transistoren 27, 28 ist ein Stromspiegel angeschlossen, umfassend zwei Gate-gekoppelte PMOS-Transistoren 30, 31, von denen letzterer als MOS-Diode verschaltet ist, in dem sein Gate- mit seinem Drain- Anschluß verbunden ist. Die Source-Anschlüsse dieser Stromspiegeltransistoren 30, 31 sind mit Versorgungspotentialanschluß 3 verbunden. Derjenige Stromspiegeltransistor 30, der nicht als Diode verschaltet ist, ist mit seinem Drain-Anschluß an den Source-Anschluß des als PMOS-Transistors ausgebildeten Schalters 5 angeschlossen, dessen Drain-Anschluß den Ausgang der Verstärkeranordnung bildet, an dem auch der Ausgang des zweiten Verstärkers 6 angeschlossen ist. Der Steueranschluß, das heißt der Gate-Anschluß des Transistors 5 ist an den Ausgang eines CMOS-Inverters 7 angeschlossen, an dessen Eingang die hier nicht eingezeichnete Auswahlschaltung 8 anschließbar ist. In Analogie zum ersten Verstärker 4 faßt auch der zweite Verstärker 6 zwei Source-seitig gekoppelte NMOS-Transistoren 32, 33, welche über eine zweite Stromquelle 34 an Bezugspotentialanschluß 15 angeschlossen sind. Drain-seitig sind die einen Differenzverstärker mit der Steilheit gm2 bildenden Transistoren 32, 33 über einen weiteren Stromspiegel, umfassend zwei PMOS-Transistoren 35, 36, miteinander und mit dem Versorgungspotentialanschluß 3 gekoppelt. Derjenige Drain-Anschluß der Stromspiegeltransistoren 35, 36, der nicht mit dem Ausgang der Verstärkeranordnung 4, 6 verbunden ist, ist als Transistordiode 36 verschaltet. Die Gate-Anschlüsse der Differenzverstärker-Transistoren 27, 28, 32, 33 sind paarweise miteinander verschaltet und bilden den ersten Eingang 9, 10 sowie den zweiten Eingang 11, 12 der Verstärker 4, 6. Obwohl die Verstärker 4, 6 augenscheinlich den gleichen Schaltungsaufbau haben, unterscheiden sie sich jedoch in der Auslegung signifikant, um sicherzustellen, daß die Steilheit gm1 des ersten Verstärkers 4 groß ist gegenüber der Steilheit gm2 des zweiten Verstärkers 6. Die vier vom ersten Verstärker 4 umfaßten Transistoren 27, 28,30, 31 sind zu diesem Zweck ausgelegt mit einer besonders großen Kanalweite und einer verhältnismäßig kleinen Kanallänge, insgesamt haben sie also ein verhältnismäßig großes Kanalweiten- zu Kanallängeverhältnis. Hierdurch ergibt sich die gemäß dem vorliegenden Prinzip vorgesehene große Treiberfähigkeit zum schnellen Auf- oder Umladen der Kapazität 2, die an den Ausgang der Verstärkeranordnung 4, 6 anschließbar ist. Die vier Transistoren 32, 33,35, 36 des zweiten Verstärkers 6 weisen hingegen eine verhältnismäßig kleine Kanalweite bei verhältnismäßig großer Kanallänge auf, so daß sich insgesamt ein sehr kleines Kanalweiten- zu Kanallängenverhältnis ergibt. Die Treiberfähigkeit ist nämlich so ausgelegt, daß Leckströme im Schalter 5 sowie Verluste in der Kapazität 2 und gegebenenfalls weitere Verluste gerade ausgeglichen werden können. Die geringe Kanalweite in Kombination mit der großen Kanallänge führt zu einem geringen 1/f-Rauschen und damit zum gemäß vorliegenden Prinzip vorgesehenen rauscharmen Betrieb eines an den Ausgang der spannungsgesteuerten Stromquelle 1 zum Abgreifen des Referenzstromes angeschlossenen Schaltung, beispielsweise eines LC-Oszillators. Insgesamt ergibt sich, daß die Steilheit gm1 des ersten Verstärkers 4 groß ist gegenüber der Steilheit gm2 des zweiten Verstärkers 6.

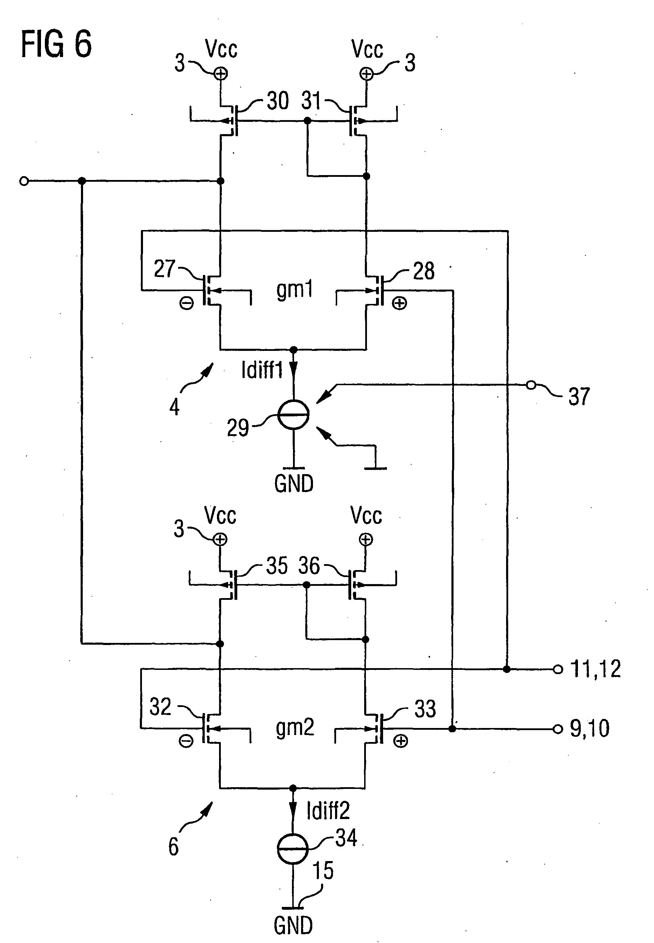

Figur 6 zeigt eine Weiterbildung des Transimpedanzverstärkers von Figur 5. Dieser entspricht in Aufbau, Verschaltung, Funktion und seinen Vorteilen weitgehend dem von Figur 5, insoweit wird die Beschreibung hier nicht wiederholt. Bezüglich dem Gegenstand von Figur 5 ist vorliegendes Ausführungsbeispiel dahingehend weitergebildet, daß die Stromquelle 29 des ersten Verstärkers 4 einen Steuereingang 37 aufweist, an dem eine Steuerspannung zugeführt wird. Dieser Steuereingang ersetzt den Schalter 5 mit Inverter 7 von Figur 5, die im vorliegenden Ausführungsbeispiel entfallen können. Die Ausgänge der Verstärker 4, 6 sind somit unmittelbar miteinander und mit dem Steuereingang der Stromquelle 1, die hier nicht eingezeichnet ist, verbunden. Der Steuereingang 37 ist mit der Auswahlschaltung 8, die hier nicht eingezeichnet ist, verbunden.

Wenn von der hohen Verstärkung gm1 nach dem Aufladen der Kapazität 2 auf die kleinere Verstärkung gm2 umgeschaltet werden soll, so erfolgt dies bei dem Gegenstand gemäß Figur 6 durch Herunterfahren des Differenzstroms der Stromquelle 29. Die Auswahlschaltung 8 stellt das hierzu erforderliche Steuersignal bereit.

Insofern kann die mit dem ersten Verstärker 4 gekoppelte steuerbare Stromquelle 29 als äquivalentes Mittel zur Serienschaltung aus Schalter 5 und dem ersten Verstärker aufgefaßt werden.

Selbstverständlich können als alternative Ausführungsformen alle vorgestellten Schaltungen im Rahmen der vorliegenden Erfindung auch in komplementärer Schaltungstechnik ausgeführt werden. So sind zum Beispiel MOS-Stromquellen sowohl mit N-Kanal-MOS-Transistoren als auch mit P-Kanal-MOS-Transistoren realisierbar. Auch die Höhe der Einsatzspannung Vₜₕ₀ der MOS-Transistoren spielt keine grundsätzliche Rolle. Weiterhin kann zum Beispiel die Funktion einer Stromspiegelschaltung in einfacher oder in aufwendiger Schaltungstechnik, zum Beispiel mit einer Kaskodeschaltung, ausgeführt werden. Derartige, alternative Ausführungen der hier angegebenen Schaltungsstrukturen können demnach als äquivalente Mittel zur Realisierung des vorliegenden Prinzips angesehen werden. Auch die Kapazität 16, die eine zusätzliche Spannungsstabilisierung über dem VCO bewirkt, kann in alternativen Ausführungsformen entfallen. Die spannungsgesteuerte Stromquelle 1 sowie die gegebenenfalls vorgesehene, ihr nachgebildete zweite spannungsgesteuerte Stromquelle 24 können anstelle der vorgestellten einfachen Realisierungen mit nur einem Feldeffekttransistor auch mit einer Kaskodeschaltung oder mit einer Gegenkoppelung ausgebildet sein.

Die Stromquellen 29, 34 können in alternativen Ausführungsformen im Rahmen des vorliegenden Prinzips auch beispielsweise als Widerstand ausgeführt sein.

Bezugszeichenliste
- 1: spannungsgesteuerte Stromquelle
- 2: Kapazität
- 3: Versorgungspotentialanschluß
- 4: erster Verstärker
- 5: Schalter
- 6: zweiter Verstärker
- 7: Inverter
- 8: Auswahlschaltung
- 9: erster Eingang
- 10: erster Eingang
- 11: zweiter Eingang
- 12: zweiter Eingang
- 13: Referenzeinheit
- 14: VCO
- 15: Bezugspotentialanschluß
- 16: Kapazität
- 17: Induktivität
- 18: Varaktor
- 19: NMOS-FET
- 20: parasitäre Quelle
- 21: parasitäres Element
- 22: parasitäres Element
- 23: parasitäres Element
- 24: zweite spannungsgesteuerte Stromquelle
- 25: Bandgap-Referenzquelle
- 26: Widerstand
- 27: NMOS-FET
- 28: NMOS-FET
- 29: Stromquelle
- 30: PMOS-FET
- 31: PMOS-FET
- 32: NMOS-FET
- 33: NMOS-FET
- 34: Stromquelle
- 35: PMOS-FET
- 36: PMOS-FET
- 37: Steuereingang
- gm1: Steilheit
- gm2: Steilheit
- I_{ref}: Referenzstrom
- V_{ref}: Referenzspannung
- ΔU: Differenzspannung
- Ref: Bezugssignaleingang

## Patentansprüche

1. Schaltungsanordnung zur Erzeugung eines Referenzstroms, aufweisend
- eine spannungsgesteuerte Stromquelle (1) mit einem Steuereingang und mit einem Ausgang zum Abgreifen des Referenzstroms (I_{ref}),
- eine Kapazität (2), die an den Steuereingang der spannungsgesteuerten Stromquelle (1) angeschlossen ist,
- eine Serienschaltung umfassend einen ersten Verstärker (4) mit einem ersten Verstärkungsfaktor (gm1) und einen Schalter (5), welche mit dem Steuereingang der spannungsgesteuerten Stromquelle (1) verbunden ist,
- einen zweiten Verstärker (6) mit einem zweiten Verstärkungsfaktor (gm2), welcher mit dem Steuereingang der spannungsgesteuerten Stromquelle (1) verbunden ist, und
- eine Auswahlschaltung (8), die zum Umschalten zwischen einer ersten und einer zweiten Betriebsart der Schaltungsanordnung mit einem Steuereingang des Schalters (5) verbunden ist.

2. Schaltungsanordnung nach Anspruch 1,
**dadurch gekennzeichnet, daß**
der erste und der zweite Verstärker (4, 6) Differenzverstärker sind.

3. Schaltungsanordnung nach Anspruch 1 oder 2,
**dadurch gekennzeichnet, daß**
der erste und der zweite Verstärker (4, 6) differenzspannungsgesteuerte Stromquellen sind, wobei der zweite Verstärkungsfaktor (gm2) so ausgelegt ist, daß gerade die Erhaltungsladung der Kapazität (8) bereitgestellt wird, und der erste Verstärkungsfaktor (gml) größer als der zweite Verstärkungsfaktor (gm2) ist.

4. Schaltungsanordnung nach einem der Ansprüche 1 bis 3,
**dadurch gekennzeichnet, daß**
der erste und der zweite Verstärker (4, 6) als in MOS-Schaltungstechnik ausgeführte, gesteuerte Stromquellen ausgebildet sind, die je einen Differenzverstärker umfassen, aufweisend je zwei MOS-Transistoren (27, 28; 32, 33), wobei das Kanalweiten- zu Kanallängenverhältnis der MOS-Transistoren (27, 28) im ersten Verstärker (4) groß ist gegenüber dem Kanalweiten- zu Kanallängenverhältnis der MOS-Transistoren (32, 33) im zweiten Verstärker (6).

5. Schaltungsanordnung nach einem der Ansprüche 1 bis 4,
**dadurch gekennzeichnet, daß**
ein Rückkopplungspfad (13) vorgesehen ist, mit einem Eingang, dem der Referenzstrom (Iref) oder ein vom Referenzstrom abgeleitetes Signal zugeführt wird und mit einem Ausgang, der an je einen Steuereingang (9, 10) des ersten und des zweiten Verstärkers (4, 6) angeschlossen ist.

6. Schaltungsanordnung nach Anspruch 5,
**dadurch gekennzeichnet, daß**
die spannungsgesteuerte Stromquelle (1) als erste spannungsgesteuerte Stromquelle ausgeführt ist und daß eine zweite, spannungsgesteuerte Stromquelle (24) vorgesehen ist, mit einem Steuereingang, der mit dem Steuereingang der ersten spannungsgesteuerten Stromquelle (1) verbunden ist und mit einem Ausgang, der mit dem Eingang des Rückkopplungspfads (13) verbunden ist.

7. Schaltungsanordnung nach Anspruch 5 oder 6,
**dadurch gekennzeichnet, daß**
erster und zweiter Verstärker (4, 6) je einen ersten Steuereingang (9, 10) und je einen zweiten Steuereingang (11, 12) aufweisen, wobei die beiden ersten Steuereingänge (9, 10) mit dem Rückkopplungspfad (13) verbunden sind und die beiden zweiten Steuereingänge (11, 12) an eine Referenzspannungsquelle (25) angekoppelt sind.

8. Schaltungsanordnung nach einem der Ansprüche 1 bis 7,
**dadurch gekennzeichnet, daß**
die Schaltungsanordnung in Metal-Oxide-Semiconductor-Schaltungstechnik aufgebaut ist.

9. Schaltungsanordnung nach einem der Ansprüche 1 bis 8,
**dadurch gekennzeichnet, daß**
der erste Verstärker (4) mit einer steuerbaren Stromquelle (29) zur Stromversorgung des ersten Verstärkers (4) gekoppelt ist, wobei die steuerbare Stromquelle (29) den Schalter (5) zum Umschalten zwischen erster und zweiter Betriebsart der Schaltungsanordnung repräsentiert.

10. Oszillatorschaltung mit einer Schaltungsanordnung nach einem der Ansprüche 1 bis 9, aufweisend
- einen LC-Schwingkreis (17, 18),
- einen Entdämpfungsverstärker (19), der mit dem LC-Schwingkreis (17, 18) gekoppelt ist, und
- einen Referenzstromeingang zum Speisen der Oszillatorschaltung (14), der an den LC-Schwingkreis (17, 18) oder an den Entdämpfungsverstärker (19) angeschlossen ist,
- wobei der Referenzstromeingang an den Ausgang der spannungsgesteuerten Stromquelle (1) der Schaltungsanordnung zur Erzeugung eines Referenzstroms angeschlossen ist.

11. Oszillatorschaltung nach Anspruch 10,
**dadurch gekennzeichnet, daß**
eine Stabilisierungskapazität (16) vorgesehen ist, welche an den Referenzstromeingang der Oszillatorschaltung (14) angeschlossen ist.

## Claims

1. Circuit arrangement for generating a reference current, having
- a voltage-controlled current source (1) having a control input and having an output for tapping off the reference current (I_{ref}),
- a capacitance (2) connected to the control input of the voltage-controlled current source (1),
- a series circuit comprising a first amplifier (4) having a first gain factor (gm1), and a switch (5) which series circuit is connected to the control input of the voltage-controlled current source (1),
- a second amplifier (6) having a second gain factor (gm2), which is connected to the control input of the voltage-controlled current source (1) and
- a selection circuit (8), which is connected to a control input of the switch (5) for the purpose of changing over between a first and a second operating mode of the circuit arrangement.

2. Circuit arrangement according to Claim 1,
**characterized in that**
the first and second amplifiers (4, 6) are differential amplifiers.

3. Circuit arrangement according to Claim 1 or 2,
**characterized in that**
the first and second amplifiers (4, 6) are differential-voltage-controlled current sources, the second gain factor (gm2) being designed such that precisely the maintenance charge of the capacitance (8) is provided, and the first gain factor (gm1) being greater than the second gain factor (gm2).

4. Circuit arrangement according to one of Claims 1 to 3,
**characterized in that**
the first and second amplifiers (4, 6) are formed as controlled current sources embodied using MOS circuit technology which each comprise a differential amplifier, each having two MOS transistors (27, 28; 32, 33), the channel width to channel length ratio of the MOS transistors (27, 28) in the first amplifier (4) being large in comparison with the channel width to channel length ratio of the MOS transistors (32, 33) in the second amplifier (6).

5. Circuit arrangement according to one of Claims 1 to 4,
**characterized in that**
a feedback path (13) is provided, having an input to which the reference current (Iref) or a signal derived from the reference current is fed and having an output connected to a respective control input (9, 10) of the first and second amplifiers (4, 6).

6. Circuit arrangement according to Claim 5,
**characterized in that**
the voltage-controlled current source (1) is embodied as a first voltage-controlled current source, and **in that** a second voltage-controlled current source (24) is provided, having a control input connected to the control input of the first voltage-controlled current source (1) and having an output connected to the input of the feedback path (13).

7. Circuit arrangement according to Claim 5 or 6,
**characterized in that**
the first and second amplifiers (4, 6) each have a first control input (9, 10) and each have a second control input (11, 12), the two first control inputs (9, 10) being connected to the feedback path (13) and the two second control inputs (11, 12) being coupled to a reference voltage source (25).

8. Circuit arrangement according to one of Claims 1 to 7,
**characterized in that**
the circuit arrangement is constructed using metal oxide semiconductor circuit technology.

9. Circuit arrangement according to one of Claims 1 to 8,
**characterized in that**
the first amplifier (4) is coupled to a controllable current source (29) for the supply of current to the first amplifier (4), the controllable current source (29) representing the switch (5) for changing over between first and second operating modes of the circuit arrangement.

10. Oscillator circuit having a circuit arrangement according to one of Claims 1 to 9, having
- an LC resonant circuit (17, 18),
- a deattenuation amplifier (19) coupled to the LC resonant circuit (17, 18) and
- a reference current input for feeding the oscillator circuit (14), which input is connected to the LC resonant circuit (17, 18) or to the deattenuation amplifier (19),
- the reference current input being connected to the output of the voltage-controlled current source (1) of the circuit arrangement for generating a reference current.

11. Oscillator circuit according to Claim 10,
**characterized in that**
a stabilization capacitance (16) is provided, which is connected to the reference current input of the oscillator circuit (14).

## Revendications

1. Montage de production d'un courant de référence, comportant
- une source (1) de courant, commandée par la tension et ayant une entrée de commande et une sortie de prélèvement du courant (I_{ref}) de référence,
- une capacité (2) qui est raccordée à l'entrée de commande de la source (1) de courant commandée par la tension,
- un circuit série comprenant un premier amplificateur (4) ayant un premier facteur (gm1) d'amplification et un commutateur (5), qui est relié à l'entrée de commande de la source (1) de courant commandée par la tension,
- un deuxième amplificateur (6) ayant un deuxième facteur (gm2) d'amplification qui est relié à l'entrée de commande de la source (1) de courant commandée par la tension, et
- un circuit (8) de sélection qui, pour commuter entre un premier et un deuxième type de fonctionnement du montage, est relié à une entrée de commande du commutateur (5).

2. Montage suivant la revendication 1,
**caractérisé en ce que**
le premier et le deuxième amplificateur (4, 6) sont des amplificateurs différentiels.

3. Montage suivant la revendication 1 ou 2,
**caractérisé en ce que**
le premier et le deuxième amplificateur (4, 6) sont des sources de courant commandées par la tension différentielle, le deuxième facteur (gm2) d'amplification étant tel qu'il est mis à disposition précisément la charge de maintien de la capacité (8), et le premier facteur (gm1) d'amplification étant plus grand que le deuxième facteur (gm2) d'amplification.

4. Montage suivant l'une des revendications 1 à 3,
**caractérisé en ce que**
le premier et le deuxième amplificateur (4, 6) sont formés en sources de courant commandées et réalisées suivant la technique de circuit MOS, qui comprennent respectivement un amplificateur différentiel ayant respectivement deux transistors (27, 28 ; 32, 33) MOS, le rapport de la largeur de canal à la longueur de canal des transistors (27, 28) MOS du premier amplificateur étant plus grand que le rapport de la largeur de canal à la longueur de canal des transistors (32, 33) MOS du deuxième amplificateur (6).

5. Montage suivant l'une des revendications 1 à 4,
**caractérisé en ce que**
il est prévu un trajet (13) de réaction ayant une entrée, à laquelle est envoyé le courant (Iref) de référence ou un signal dérivé du courant de référence, et ayant une sortie qui est raccordée à respectivement une entrée (9, 10) de commande du premier et du deuxième amplificateur (4, 6).

6. Montage suivant la revendication 5,
**caractérisé en ce que**
la source (1) de courant commandée par la tension est réalisée en première source de courant commandée par la tension, et **en ce qu'**il est prévu une deuxième source (24) de courant commandée par la tension et ayant une entrée de commande qui est reliée à l'entrée de commande de la première source (1) de courant commandée par la tension et une sortie qui est reliée à l'entrée du trajet (13) de réaction.

7. Montage suivant la revendication 5 ou 6,
**caractérisé en ce que**
le premier et le deuxième amplificateur (4, 6) ont respectivement une première entrée (9, 10) de commande et respectivement une deuxième entrée (11, 12) de commande, les deux premières entrées (9, 10) de commande étant reliées au trajet (13) de réaction et les deux deuxièmes entrées (11, 12) de commande étant couplées à une source (25) de tension de référence.

8. Montage suivant l'une des revendications 1 à 7,
**caractérisé en ce que**
le montage est constitué en technique de circuit métal-oxyde-semi-conducteur.

9. Montage suivant l'une des revendications 1 à 8,
**caractérisé en ce que**
le premier amplificateur (4) est couplé à une source (29) de courant pouvant être commandée pour l'alimentation en courant du premier amplificateur (4), la source (29) de courant pouvant être commandée représentant le commutateur (5) de commutation entre un premier et un deuxième type de fonctionnement du montage.

10. Circuit d'oscillateur ayant un montage suivant l'une des revendications 1 à 9, et comprenant
- un circuit (17, 18) oscillant LC,
- un amplificateur (19) de compensation de l'amortissement, qui est couplé au circuit (17, 18) oscillant LC, et
- une entrée de courant de référence pour alimenter le circuit (14) de l'oscillateur, qui est raccordé au circuit (17, 18) oscillant LC ou à l'amplificateur (19) de compensation de l'amortissement,
- dans lequel l'entrée du courant de référence est raccordée à la sortie de la source (1) de courant commandée par la tension du montage de production d'un courant de référence.

11. Circuit d'oscillateur suivant la revendication 10,
**caractérisé en ce que**
il est prévu une capacité (16) de stabilisation, qui est raccordée à l'entrée du courant de référence du circuit (14) d'oscillateur.
